**Europäisches Patentamt**

**European Patent Office**

**Office européen des brevets**

(19)

(11) **EP 0 854 582 B1**

(12) **FASCICULE DE BREVET EUROPEEN**

(45) Date de publication et mention
de la délivrance du brevet:
**17.04.2002 Bulletin 2002/16**

(51) Int Cl.⁷: **H04B 1/10**, H03G 3/34,
H04M 1/725

(21) Numéro de dépôt: **98200086.1**

(22) Date de dépôt: **14.01.1998**

(54) **Méthode de réduction des clics dans un système de transmission de données**

Verfahren zur Unterdrückung der Klickgeräusche in einem Datenübertragungssystem

Click noise reduction method in a data transmission system

(84) Etats contractants désignés:
**DE FR GB IT**

(30) Priorité: **21.01.1997 FR 9700581**

(43) Date de publication de la demande:
**22.07.1998 Bulletin 1998/30**

(73) Titulaire: **Koninklijke Philips Electronics N.V.
5621 BA Eindhoven (NL)**

(72) Inventeur: **Auroux, Elisabeth
75008 Paris (FR)**

(74) Mandataire: **Chaffraix, Jean
Société Civile S.P.I.D.
156, Boulevard Haussmann
75008 Paris (FR)**

(56) Documents cités:
**EP-A- 0 552 005       EP-A- 0 571 078
EP-A- 0 645 756       EP-A- 0 665 530
US-A- 5 333 153       US-A- 5 533 133**

**Description**

L'invention concerne un système de transmission de données codées numériquement, comportant au moins un émetteur et un récepteur, ledit récepteur comportant lui-même des moyens de décodage qui délivrent des échantillons, des moyens de détection de silence dans lesdits échantillons, des moyens de traitement d'échantillons.

L'invention concerne également une méthode de réduction de l'effet d'erreurs de transmission sur des échantillons délivrés en sortie de moyens de décodage d'un système de transmission de données codées numériquement.

L'invention concerne enfin un téléphone sans fil comportant une base et un combiné dotés chacun de moyens d'émission / réception pour échanger des données codées numériquement, lesdits moyens de réception comportant des moyens de décodage qui délivrent des échantillons, des moyens de détection de silence dans lesdits échantillons, des moyens de traitement d'échantillons.

L'invention a d'importantes applications, notamment dans le domaine de la téléphonie sans fil, où elle permet d'améliorer sensiblement le confort d'écouté pour l'utilisateur.

La demande de brevet internationale n°94/29851 porte sur un système de transmission de parole par voie radio sous forme de trames, et décrit plusieurs méthodes pour diminuer l'effet des erreurs de transmission sur les échantillons délivrés en sortie du décodeur. L'une de ces méthodes consiste notamment à atténuer globalement les échantillons délivrés en sortie du décodeur lorsque des erreurs de transmission sont détectées pendant plusieurs trames successives.

Toutefois, une telle méthode ne permet pas de prendre en compte les erreurs de transmission isolées qui apparaissent avec une probabilité relativement élevée notamment dans le cas d'une transmission entre une base et un combiné d'un téléphone sans fil.

La demande de brevet européen n°0 645 756 décrit un système de transmission par voie radio, sous forme de trames. Ce système comporte un récepteur qui utilise une méthode de réduction du bruit de fond contenu dans les signaux qu'il reçoit. La méthode décrite consiste à estimer le bruit de fond, et à détecter les trames de silence. Lorsqu'il y a du bruit de fond, une première atténuation variable est appliquée à chaque échantillon de la trame courante, que cette trame soit ou non une trame de parole. Et une seconde atténuation variable est en plus appliquée à tous les échantillons des trames qui sont des trames de silence.

Cette méthode ne permet pas de corriger les échantillons parasites dus aux erreurs de transmission.

L'invention a notamment pour but de proposer une méthode de réduction de l'effet d'erreurs de transmission sur des échantillons délivrés en sortie de moyens de décodage d'un système de transmission de données codées numériquement.

Pour cela, un système de transmission selon l'invention et tel que décrit dans le paragraphe introductif est caractérisé en ce que ledit récepteur comporte des moyens de détection dans ledit silence d'échantillons parasites dus à des erreurs de transmission, et en ce que lesdits moyens de traitement sont prévus pour traiter les échantillons parasites dus à des erreurs de transmission qui sont situés dans le silence, à l'exclusion des échantillons parasites dus à des erreurs de transmission qui ne sont pas situés dans le silence.

Une méthode selon l'invention et telle que décrite dans le paragraphe introductif comporte une étape de détection de silence dans lesdits échantillons, une étape de détection, dans ledit silence, d'échantillons parasites dus aux dites erreurs de transmission, et une étape de traitement des échantillons parasites dus à des erreurs de transmission qui sont situés dans le silence, à l'exclusion des échantillons parasites dus à des erreurs de transmission qui ne sont pas situés dans le silence.

Et un téléphone selon l'invention et tel que décrit dans le paragraphe introductif est caractérisé en ce que lesdits moyens de réception comportent des moyens de détection dans ledit silence d'échantillons parasites dus à des erreurs de transmission, et en ce que lesdits moyens de traitement sont prévus pour traiter les échantillons parasites dus à des erreurs de transmission qui sont situés dans le silence, à l'exclusion des échantillons parasites dus à des erreurs de transmission qui ne sont pas situés dans le silence.

L'invention présente donc l'avantage d'atténuer les échantillons parasites dus aux erreurs de transmission, même isolés, lorsqu'ils se situent dans du silence, c'est-à-dire lorsqu'ils sont particulièrement gênants pour l'utilisateur.

Les erreurs de transmission isolées apparaissent avec une probabilité relativement élevée notamment dans le cas d'une transmission entre une base et un combiné d'un téléphone sans fil.

Dans un mode de réalisation particulièrement avantageux de la présente invention, lesdits moyens de détection d'échantillons parasites comportent des moyens de comparaison de l'amplitude des échantillons à une valeur de référence, calculée sur plusieurs échantillons précédents, et supérieure à une valeur minimum.

Dans ce mode de réalisation, un échantillon présentant un pic d'amplitude inférieure à une valeur minimum n'est pas détecté comme un parasite, même s'il suit une pluralité d'échantillons dont l'amplitude était pratiquement nulle.

Dans un autre mode de réalisation de l'invention, lesdits échantillons sont transmis par trames, et une trame est détectée comme étant une trame de silence par comparaison des amplitudes de ses échantillons, prises isolément ou en moyenne, à un seuil prédéterminé. De façon avantageuse, des moyens sont prévus pour distinguer parmi lesdites trames de silence, des trames dites trames de silence inter-syllabes et des trames dites trames de silence établi, et lesdits moyens d'activation permettent de traiter chaque échantillon parasite d'une trame de silence établi, et une pluralité d'échantillons suivant chacun desdits échantillons parasites.

Le fait de traiter plusieurs échantillons après l'échantillon parasite est particulièrement avantageux lorsque le codage qui est fait au niveau de l'émetteur avant la transmission est un codage différentiel. Dans ce cas, et afin d'éviter d'atténuer des échantillons de parole, on choisit avantageusement de ne pas traiter le silence inter-syllabes.

L'invention sera mieux comprise et d'autres détails apparaîtront à la lumière de la description qui va suivre en regard des dessins annexés qui sont donnés à titre d'exemples non limitatifs et dans lesquels:

- la figure 1 représente un exemple de système de transmission selon l'invention.
- les figures 2 à 4 représentent des exemples d'organigramme de fonctionnement d'une méthode de traitement d'échantillons selon l'invention.
- la figure 5 donne un exemple des résultats obtenus grâce à l'invention, sur un signal de silence,
- la figure 6 donne un exemple des résultats obtenus après application d'une méthode selon l'invention à un signal de parole.

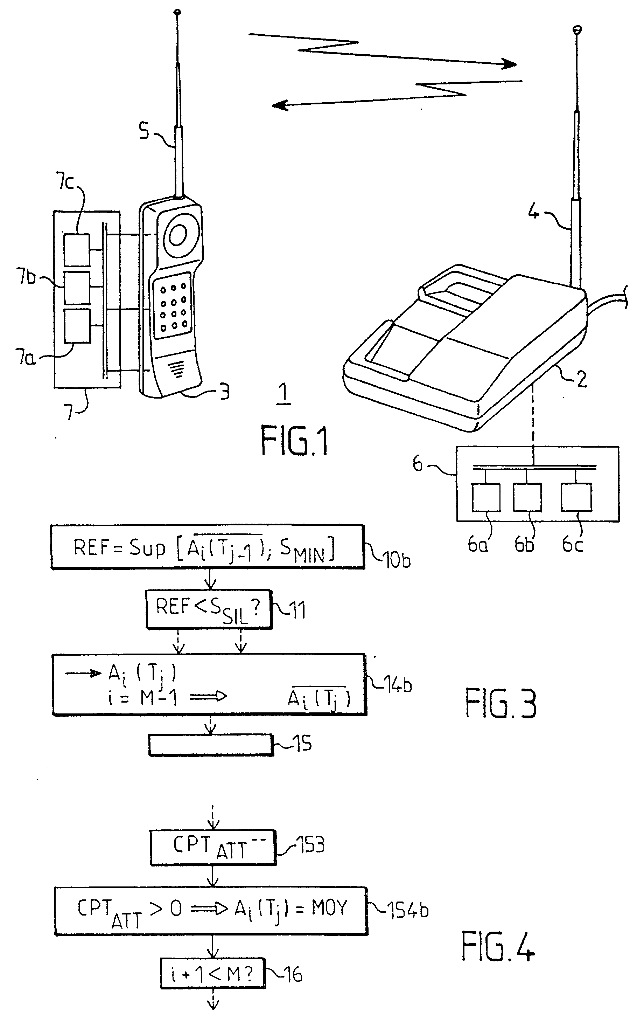

Sur la figure 1, on a représenté à titre d'exemple un système de transmission selon l'invention qui est constitué par un téléphone sans fil 1. Ce téléphone sans fil comporte une base 2 et un combiné 3 respectivement dotés d'une antenne 4 et 5, et de moyens d'émission/ réception pour échanger des données (notamment de la parole) par voie radio.

Dans la suite, le téléphone décrit à titre d'exemple est un téléphone conforme à la norme DECT définie par l'ETSI (référence ETS 300 175). Lesdits moyens d'émission/réception de la base et du combiné comportent donc des moyens de codage/décodage de parole de type ADPCM (de l'anglais Adaptative Differential Pulse Code Modulation) définis dans la recommandation G.721 du CCITT.

Lesdits moyens d'émission/réception, lesdits moyens de codage/décodage et les moyens selon l'invention qui vont être décrits par la suite sont avantageusement mis en oeuvre sous forme logicielle à partir d'un ensemble à microprocesseur 6 et 7 respectivement. Ces ensembles à microprocesseur sont par exemple constitués, pour le combiné et pour la base respectivement, par les circuits PCD 5091F3/31 et PCD 5092F3/41 fabriqués par Philips Semiconductors. Ils comportent respectivement un microprocesseur proprement dit 6a et 7a, de la mémoire vive 6b et 7b, et de la mémoire morte 6c et 7c dans laquelle sont notamment stockées des instructions nécessaires au fonctionnement desdits moyens d'émission/réception et de codage/décodage.

Une mauvaise qualité de la liaison radio entre la base et le combiné est susceptible d'entraîner des erreurs sur les éléments binaires transmis, ce qui provoque l'apparition d'échantillons parasites (couramment appelés "clics") en sortie des moyens de décodage, créant ainsi une gêne d'autant plus importante, que les échantillons parasites se situent dans des périodes de silence.

L'invention consiste notamment à agir sur les échantillons délivrés par lesdits moyens de décodage afin de traiter les échantillons parasites qui se situent dans des périodes de silence et dont l'amplitude dépasse une valeur prédéterminée. Dans une première variante de réalisation de l'invention, ce traitement consiste à atténuer lesdits échantillons. Dans une autre variante il consiste à remplacer les échantillons parasites par une valeur moyenne MOY calculée à partir des échantillons reçus.

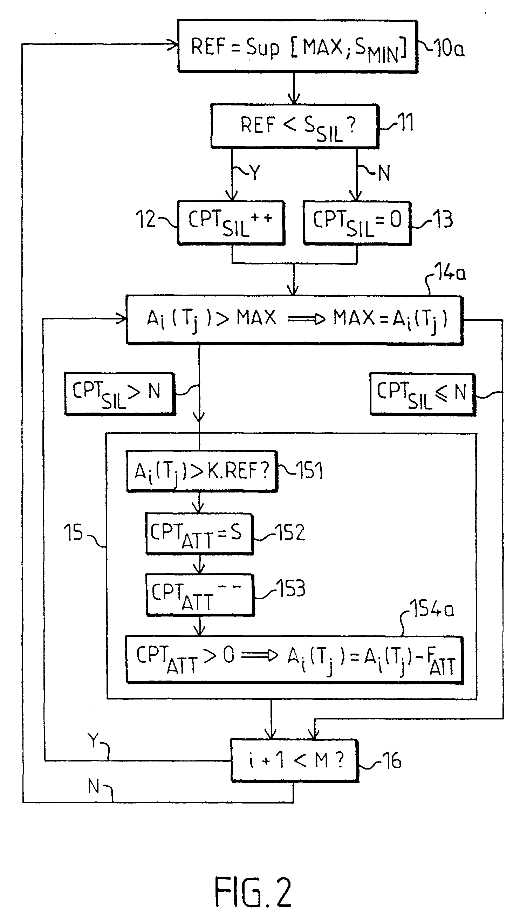

Dans la suite de la description, on décrit en référence aux figures 2, 3 et 4 un mode de réalisation particulièrement avantageux de l'invention en reprenant le découpage par trame utilisé dans la norme DECT.

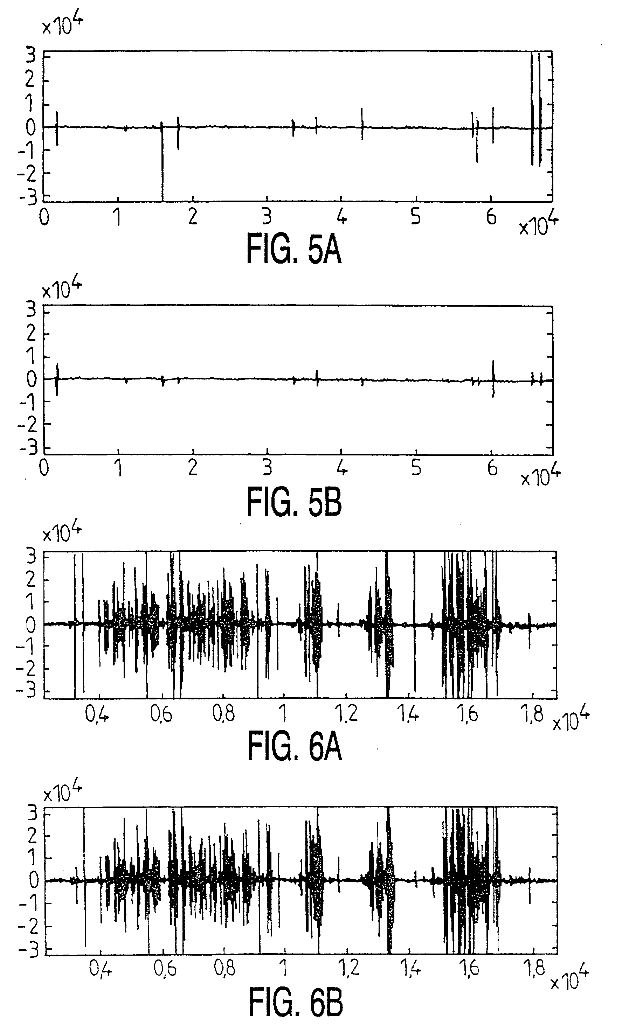

Au début de chaque trame $T_j$, le procédé reprend à la case 10a ou à la case 10b des organigrammes des figures 2 et 3 pour définir une valeur REF représentative du niveau des échantillons de la trame précédente $T_{j-1}$. Selon une première variante représentée sur la figure 2 à la case 10a, cette valeur REF est égale:

- au maximum MAX des amplitudes $A_i(T_{j-1})$ des échantillons de la trame précédente si ce maximum est supérieur à une valeur minimum $S_{MIN}$.
- et à la valeur minimum $S_{MIN}$ sinon.

Selon une seconde variante représentée sur la figure 3 à la case 10b, la valeur REF est égale:

- à une valeur moyenne $\overline{A_i(T_{j-1})}$ des amplitudes $A_i$ $(T_{j-1})$ des échantillons de la trame précédente si cette valeur moyenne est supérieure à une valeur minimum $S_{MIN}$.
- et à la valeur minimum $S_{MIN}$ sinon.

Le procédé se poursuit ensuite à la case 11. A la case 11 on détermine si la trame précédente $T_{j-1}$ est une trame de silence en comparant la valeur REF calculée aux cases 10a ou 10b avec un seuil de silence noté $S_{SIL}$. Si REF<$S_{SIL}$, la trame $T_{j-1}$ est une trame de silence, et, à la case 12, on incrémente d'une unité un compteur de trames de silence noté $CPT_{SIL}$. Sinon, la trame $T_{j-1}$ n'est pas une trame de silence, et, à la case 13, le compteur $CPT_{SIL}$ est remis à zéro. Comme on le verra par la suite, c'est ce compteur $CPT_{SIL}$ qui va permettre de distinguer le silence établi du silence inter-syllabes puisqu'on ne considérera qu'une trame est une trame de silence établi qu'après avoir reçu N trames successives de silence.

Pour chaque échantillon i reçu, on met ensuite à jour les données relatives à la trame courante $T_j$ qui seront utilisées pour la trame suivante $T_{j+1}$.

Pour cela, et conformément à la première variante de réalisation de l'invention représentée sur la figure 2 à la case 14a, on compare la valeur de l'amplitude $A_i(T_j)$ de l'échantillon i à celle d'une variable MAX qui contient l'amplitude maximum déjà reçue pour la trame courante $T_j$. Et si $A_i(T_j) >$ MAX, alors on attribue la valeur $A_i(T_j)$ à la variable MAX.

Et conformément à la seconde variante de l'invention représentée sur la figure 3 à la case 14b, on comptabilise l'amplitude $A_i(T_j)$ de l'échantillon i, et lorsque i=M-1, une valeur moyenne $\overline{A_i(T_j)}$ est calculée avec les M valeurs comptabilisées pour la trame j.

Le fonctionnement se poursuit alors à la case 15 si la valeur du compteur de silence $CPT_{SIL}$ dépasse la valeur N. Sinon, il se passe directement à la case 16.

A la case 15, pour chaque échantillon i reçu dans la trame courante $T_j$, on réalise les opérations suivantes:

- case 151: on compare l'amplitude $A_i(T_j)$ de l'échantillon reçu, en valeur absolue, avec la valeur de référence REF elle-même multipliée par un facteur K.
- Si $|A_i(Tj)| >$ K.REF, on atténue l'échantillon i et les S échantillons suivants. Pour cela, à la case 152, on initialise un compteur d'atténuation $CPT_{ATT}$ à la valeur S. Puis, à la case 153, on décrémente ce compteur d'une unité.
- A la case 154a et à la case 154b des organigrammes des figures 2 et 4, on teste si la valeur du compteur $CPT_{ATT}$ est positive. Si c'est le cas, selon une première variante représentée à la case 154a, l'échantillon i est atténué d'un facteur $F_{ATT}$. Et selon une seconde variante représentée à la case 154b, l'échantillon i est remplacé par une valeur moyenne MOY, qui est par exemple égale à une valeur moyenne des amplitudes $A_i(T_{j-1})$ des échantillons de la trame précédente $T_{j-1}$.

A la case 16, on teste la valeur de l'indice i. Tant que i+1<M où M est le nombre d'échantillons par trame, le fonctionnement reprend à la case 14 pour l'échantillon suivant i+1 de la trame $T_j$. Lorsque i+1=M, la trame $T_j$ a été entièrement traitée, l'indice i est ré-initialisé à la valeur zéro, et le fonctionnement reprend à la case 10.

Dans ce mode de réalisation, on atténue donc tous les échantillons d'une trame de silence établi dont l'amplitude dépasse un seuil donné, ainsi que les (S-1) échantillons suivants. Une fois qu'un échantillon parasite a été détecté dans une trame de silence établi, l'atténuation est donc susceptible d'être appliquée sur au moins S échantillons et au plus S+M échantillons. Au delà des S+M échantillons, il faudra attendre le passage de N nouvelles trames de silence avant de pouvoir atténuer à nouveau les échantillons parasites.

Dans la pratique, on choisit par exemple les valeurs suivantes:

- $S_{MIN}$ =-48 dB,
- $S_{SIL}$ =-30 dB,
- N=5; la durée de la trame DECT étant de 10ms, une valeur de N=5 correspond donc à une durée très courte pendant laquelle les échantillons parasites sont susceptibles de ne pas être atténués. Cette mesure réduit donc dans certains cas l'efficacité de la méthode selon l'invention, mais elle permet de garantir que, en cas de détection erronée de parasites, au plus [(S+M)/M].10 ms de parole seront perdues.
- K=16, ce qui signifie que, pour être atténué, l'amplitude d'un échantillon doit dépasser seize fois l'amplitude maximum relevée sur la trame précédente.
- $F_{ATT}$=18dB.
- et S=160, soit 2 trames DECT puisqu'une trame DECT contient 80 échantillons.

Sur les figures 5 et 6, on a représenté à titre d'exemple des résultats obtenus en utilisant ces valeurs. Sur ces figures, on a porté en abscisse le rang des échantillons, et en ordonnée leur amplitude (cette amplitude est codée sur 16 bits et varie donc entre -32768 et +32767). La figure 5a représente un signal de silence avec des erreurs. La figure 5b représente le même signal de silence, après atténuation des échantillons parasites conformément à la méthode qui vient d'être décrite: la plupart des échantillons parasites sont bien atténués.

La figure 6a représente un signal de parole contenant des erreurs, et la figure 6b représente le même signal après application de la méthode selon l'invention: on constate que le signal de parole n'est pas altéré par l'utilisation de cette méthode.

Il va de soi que l'invention n'est pas limitée au mode de réalisation qui vient d'être décrit à titre d'exemple.

En particulier, l'invention s'applique de façon particulièrement avantageuse à tous les systèmes de téléphonie sans fil qui utilise un codage de type ADPCM. En effet, la fréquence des échantillons parasites introduits en sortie d'un décodeur ADPCM (qui se situe typiquement autour de 1000Hz à 1200Hz) appartient à la bande de fréquence du signal utile (jusqu'à 3800Hz pour la parole). Dans ce cas, il est donc impossible de discriminer le signal utile des clics par une méthode classique de filtrage, et l'invention apporte une solution particulièrement simple et efficace à ce problème.

Par ailleurs, il est possible d'utiliser différentes variantes des modes de réalisation qui viennent d'être décrits à titre d'exemple: par exemple, on peut appliquer d'autres critères de détection de silence, et de la présence d'échantillons parasites dans ce silence.

## Revendications

1. Système de transmission de données codées numériquement, comportant au moins un émetteur et un récepteur, ledit récepteur comportant lui-même des moyens de décodage qui délivrent des échantillons, des moyens de détection de silence dans lesdits échantillons, et des moyens de traitement d'échantillons,
**caractérisé en ce que** ledit récepteur comporte des moyens de détection dans ledit silence d'échantillons parasites dus à des erreurs de transmission, et **en ce que** lesdits moyens de traitement sont prévus pour traiter les échantillons parasites dus à des erreurs de transmission qui sont situés dans le silence, à l'exclusion des échantillons parasites dus à des erreurs de transmission qui ne sont pas situés dans le silence.

2. Système de transmission selon la revendication 1, **caractérisé en ce que** lesdits moyens de détection d'échantillons parasites comportent des moyens de comparaison de l'amplitude des échantillons à une valeur de référence, calculée sur plusieurs échantillons précédents, et supérieure à une valeur minimum.

3. Système de transmission selon l'une des revendications 1 ou 2, dans lequel lesdits échantillons sont transmis par trames, **caractérisé en ce qu'**une trame est détectée comme étant une trame de silence par comparaison des amplitudes de ses échantillons, prises isolément ou en moyenne, à un seuil prédéterminé.

4. Système de transmission selon la revendication 3, **caractérisé en ce que** lesdits moyens de traitement sont prévus pour traiter chaque échantillon parasite d'une trame de silence.

5. Système de transmission selon la revendication 3, **caractérisé en ce qu'**il comporte des moyens de distinction, parmi les trames de silence, de trames de silence dites trames de silence établi, une trame de silence étant considérée comme une trame de silence établi après que plusieurs trames de silence successives ont été détectées, et **en ce que** lesdits moyens de traitement sont prévus pour traiter chaque échantillon parasite d'une trame de silence établi.

6. Système de transmission selon la revendication 5, **caractérisé en ce que** lesdits moyens de traitement sont prévus pour traiter une pluralité d'échantillons qui suivent lesdits échantillons parasites d'une trame de silence établi.

7. Méthode de réduction de l'effet d'erreurs de transmission sur des échantillons délivrés en sortie de moyens de décodage d'un système de transmission de données codées numériquement, ladite méthode comportant une étape de détection de silence dans lesdits échantillons, une étape de détection, dans ledit silence, d'échantillons parasites dus aux dites erreurs de transmission, et une étape de traitement des échantillons parasites dus à des erreurs de transmission qui sont situés dans le silence, à l'exclusion des échantillons parasites dus à des erreurs de transmission qui ne sont pas situés dans le silence.

8. Téléphone sans fil comportant une base et un combiné dotés chacun de moyens d'émission /réception pour échanger des données codées numériquement, lesdits moyens de réception comportant des moyens de décodage qui délivrent des échantillons, des moyens de détection de silence dans lesdits échantillons, et des moyens de traitement d'échantillons, **caractérisé en ce que** lesdits moyens de réception comportent des moyens de détection dans ledit silence d'échantillons parasites dus à des erreurs de transmission, et **en ce que** lesdits moyens de traitement sont prévus pour traiter les échantillons parasites dus à des erreurs de transmission qui sont situés dans le silence, à l'exclusion des échantillons parasites dus à des erreurs de transmission qui ne sont pas situés dans le silence.

9. Téléphone sans fil selon la revendication 8, **caractérisé en ce qu'**il est conforme à la norme DECT.

## Patentansprüche

1. Übertragungssystem digital kodierter Daten mit mindestens einem Sender und einem Empfänger, wobei der besagte Empfänger selbst Dekodierverfahren zur Lieferung von Mustern, Verfahren zur Stilleerkennung in den besagten Mustern und Verfahren zur Verarbeitung der Muster enthält,
**dadurch gekennzeichnet, daß** der besagte Empfänger Verfahren zur Erkennung in der besagten Stille von Störmustern enthält, die auf Übertragungsfehler zurückzuführen sind, und daß die besagten Verarbeitungsverfahren vorgesehen sind, um Störmuster zu verarbeiten, die auf Übertragungsfehler zurückzuführen sind, die innerhalb der Stille liegen, unter Ausschluß der Störmuster, die auf Übertragungsfehler zurückzuführen sind, die nicht innerhalb der Stille liegen.

2. Übertragungssystem nach Anspruch 1, **dadurch gekennzeichnet, daß** die besagten Verfahren zur Erkennung von Störmustern Verfahren zum Vergleichen der Amplituden der Muster mit einem Bezugswert enthalten, berechnet über mehrere vorhergehende Muster und über einem Mindestwert.

**3.** Übertragungssystem nach einem der Ansprüche 1 oder 2, **dadurch gekennzeichnet, daß** die besagten Muster in Rastern übertragen werden, und ein Raster wird als Stillraster erkannt, indem die Amplituden seiner Muster verglichen werden, einzeln oder im Durchschnitt genommen, ab einer vorbestimmten Schwelle.

**4.** Übertragungssystem nach Anspruch 3, **dadurch gekennzeichnet, daß** die besagten Verarbeitungsverfahren. vorgesehen sind, um jedes Störmuster eines Stillerasters zu verarbeiten.

**5.** Übertragungssystem nach Anspruch 3, **dadurch gekennzeichnet, daß** es Verfahren aufweist, um unter den Stillerastern sogenannte etablierte Stilleraster zu unterscheiden, wobei ein Stilleraster als etabliertes Stilleraster betrachtet wird, nachdem mehrere aufeinanderfolgende Stilleraster erkannt wurden, und daß die besagten Verarbeitungsverfahren vorgesehen sind, um jedes Störmuster eines etablierten Stillerasters zu verarbeiten.

**6.** Übertragungssystem nach Anspruch 5, **dadurch gekennzeichnet, daß** die besagten Verarbeitungsmittel vorgesehen sind, um eine Vielzahl an Mustern zu verarbeiten, die den besagten Störmustern eines etablierten Stillerasters folgen.

**7.** Methode zur Unterdrückung des Effektes der Fehlerübertragung auf die am Ausgang der Dekodierverfahren eines Übertragungssystems digital kodierter Daten gelieferten Muster, wobei die besagte Methode einen Schritt zur Erkennung der Stille in den besagten Mustern, einen Schritt zur Erkennung in der besagten Stille von Störmustern, die auf besagte Übertragungsfehler zurückzuführen sind, und einen Schritt zur Verarbeitung der Störmuster umfaßt, die auf Übertragungsfehler zurückzuführen sind, die innerhalb der Stille liegen, unter Ausschluß der Störmuster, die auf Übertragungsfehler zurückzuführen sind, die nicht innerhalb der Stille liegen.

**8.** Schnurloses Telefon mit einem Sockel und einem Hörer/Mikrofon, jeweils mit Sende/Empfangs-Verfahren versehen, um digital kodierte Daten auszutauschen, wobei die besagten Empfangsverfahren Dekodierverfahren zur Lieferung von Mustern, Verfahren zur Stilleerkermung in den besagten Mustern und Verfahren zur Verarbeitung der Muster entbalten, **dadurch gekennzeichnet, daß** die besagten Empfangsverfahren Verfahren zur Erkennung von Störmustern in der besagten Stille enthalten, die auf Übertragungsfehler zurückzuführen sind, und daß die besagten Verarbeitungsverfahren vorgesehen sind, um Störmuster zu verarbeiten, die auf Übertragungsfehler zurückzuführen sind, die innerhalb der Stille liegen, unter Ausschluß von Störmustern, die auf Übertragungsfehler zurückzuführen sind, die nicht innerhalb der Stille liegen.

**9.** Schnurloses Telefon nach Anspruch 8, **dadurch gekennzeichnet, daß** es der DECT-Norm entspricht.

## Claims

**1.** A transmission system for transmitting digitally coded data, comprising at least a transmitter and a receiver, said receiver itself comprising decoding means which produce samples, detection means for detecting silence in said samples and sample processing means, **characterized in that** said receiver comprises detection means for detecting in said silence parasitic samples which occur owing to transmission errors, and **in that** said processing means are provided for processing the parasitic samples caused by transmission errors which are situated in the silence, with the exclusion of the parasitic samples which occur owing to transmission errors which are not situated in the silence,

**2.** The transmission system as claimed in claim 1, **characterized in that** said detection means for detecting parasitic samples comprise comparing means for comparing the amplitude of the samples to a reference value, computed over various preceding samples and higher than a minimum value,

**3.** A transmission system as claimed in one of the claims 1 or 2, in which said samples are transmitted in frames, **characterized in that** a frame is detected as being a silence frame when the amplitudes of its samples, taken individually or on average are compared with a predetermined threshold.

**4.** A transmission system as claimed in claim 3, **characterized in that** said processing means are provided for processing each parasitic sample of a silence frame.

**5.** , A transmission system as claimed in claim 3, **characterized in that** it comprises distinguishing means for distinguishing among the silence frames called established silence frames, a silence frame being considered an established silence frame after various successive silence frames have been detected, and **in that** said processing means are provided for processing each parasitic sample of an established silence frame.

**6.** A transmission system as claimed in claim 5, **char-**

**acterized in that** said processing means are provided for processing a plurality of samples that follow said parasitic samples of an established silence frame.

7. A method of reducing the effect of transmission errors on samples produced on the output of decoding means of a transmission system for transmitting digitally coded data, said method comprising a step of detecting silence in said samples, a step of detecting parasitic samples in said silence which occur owing to said transmission errors, and a step of processing parasitic samples which occur owing to transmission errors which are situated in the silence, with the exclusion of parasitic samples which occur owing to transmission errors which are not situated in the silence.

8. A wireless telephone comprising a base and a handset each having a transceiver means for exchanging digitally coded data, said receiving means comprising decoding means which produce samples, detection means for detecting silence in said samples, and sample processing means, **characterized in that** said receiving means comprise means for detecting parasitic samples in said silence which occur owing to transmission errors, and **in that** said processing means are provided for processing the parasitic samples which occur owing to transmission errors which are situated in the silence, with the exclusion of parasitic samples which occur owing to transmission errors which are not situated in the silence,

9. The wireless telephone as claimed in claim 8, **characterized in that** it is in conformity with the DECT standard.

FIG.1

$$REF = Sup \left[ \overline{A_i(T_{j-1})} ; S_{MIN} \right]$$ —10b

$$REF < S_{SIL} ?$$ —11

$$\longrightarrow A_i (T_j)$$
$$i = M-1 \Longrightarrow \overline{A_i(T_j)}$$ —14b

FIG.3

—15

$$CPT_{ATT}^{--}$$ —153

$$CPT_{ATT} > 0 \Longrightarrow A_i(T_j) = MOY$$ —154b

FIG.4

$$i + 1 < M ?$$ —16

FIG.2

FIG. 5A

FIG. 5B

FIG. 6A

FIG. 6B